# EUROPEAN PATENT APPLICATION

(11) **EP 4 542 338 A1**
(43) Date of publication of application: **23.04.2025**
(21) Application number: 24195587.1
(22) Date of filing: 21.08.2024
(51) Int. Cl.: G06F 1/20, H05K 1/02

(54) **STORAGE ELEMENT ASSEMBLY AND ELECTRONIC DEVICE**

(30) Priority: 18.10.2023 CN 202311351627
(71) Applicant: Getac Technology Corporation, New Taipei City 221009 (TW)
(72) Inventor: CHENG, Hung-Chan, Taipei City 115 (TW); CHOU, Po-Heng, Taipei City 115 (TW)
(74) Representative: Lucke, Andreas

(57) **Abstract**

A storage element assembly includes two storage elements and a connecting piece. Each storage element has a first side and a second side opposite to each other and a third side and a fourth side opposite to each other, the third side and the fourth side are connected between the first side and the second side, and the third sides of the storage elements are opposite to each other and spaced by a gap. The connecting piece has two wrapping portions and a bridging portion, each wrapping portion wraps the first side, the second side, and the fourth side of one of the storage elements, and the bridging portion is connected between the wrapping portions and covers the gap. The present invention further provides an electronic device with the storage element assembly.

## Description

### FIELD OF THE INVENTION

The present invention relates to a storage element, and more particularly to a storage element assembly installed in an electronic device, and the electronic device using the same.

### BACKGROUND OF THE INVENTION

Portable electronic devices are important in the modern busy commercial society. A common portable electronic device includes various electronic elements such as a battery, a processor, and a memory. Because the working efficiency of the electronic elements is affected by the temperature, how to dissipate heat is one of important design issues for portable electronic devices.

### SUMMARY OF THE INVENTION

The present invention provides a storage element assembly having a good heat dissipation effect.

The present invention further provides an electronic device in which a storage element assembly has a good heat dissipation effect.

To achieve the above advantages, an embodiment of the present invention provides a storage element assembly, including two storage elements and a connecting piece. Each storage element has a first side and a second side opposite to each other and a third side and a fourth side opposite to each other, the third side and the fourth side are connected between the first side and the second side, and the third sides of the storage elements are opposite to each other and spaced by a gap. The connecting piece has two wrapping portions and a bridging portion, each wrapping portion wraps the first side, the second side, and the fourth side of one of the storage elements, and the bridging portion is connected between the wrapping portions and covers the gap.

In an embodiment of the present invention, the connecting piece comprises a metal layer and a wave-absorbing layer, the metal layer is superimposed on the wave-absorbing layer, and the wave-absorbing layer is located between the metal layer and the storage elements.

In an embodiment of the present invention, the connecting piece further comprises an insulating layer, and the metal layer is located between the wave-absorbing layer and the insulating layer.

In an embodiment of the present invention, each of the third sides is provided with an electrical connection portion.

An embodiment of the present invention provides an electronic device, including a mainboard and the storage element assembly. The storage element assembly is arranged on the mainboard.

In an embodiment of the present invention, the mainboard is provided with two connecting slots, each of the third sides is provided with an electrical connection portion, the electrical connection portions of the third sides are inserted into the connecting slots, respectively, and the bridging portion covers the connecting slots.

In an embodiment of the present invention, the electronic device further includes a fan configured to generate an airflow, where the airflow passes through the connecting piece.

In an embodiment of the present invention, the electronic device further includes a housing, where the housing includes an air inlet and an air outlet, the fan is arranged at the air outlet, the storage element assembly is located between the air inlet and the fan, and the airflow flows through a space between the connecting piece and the housing.

In an embodiment of the present invention, the housing includes a bottom board and a side board, the air inlet is located on the bottom board, and the air outlet is located on the side board.

Based on the above description, the storage element assembly according to the present invention has good heat dissipation performance because the storage element assembly is wrapped by the wrapping portions of the connecting piece and the bridging portion capable of increasing a heat dissipation area is formed between the two wrapping portions. The electronic device according to the present invention includes the storage element assembly and thus has good heat dissipation performance. The two storage elements are both wrapped by the connecting piece, and the connecting slots for connecting the storage elements are also covered by the bridging portion, so signal interference caused by the storage elements can be reduced and thus interference noise can be reduced.

Other objectives, features and advantages of the invention will be further understood from the further technological features disclosed by the embodiments of the invention wherein there are shown and described preferred embodiments of this invention, simply by way of illustration of modes best suited to carry out the invention.

### BRIEF DESCRIPTION OF THE DRAWINGS

FIG. 1 is a schematic three-dimensional view of a storage element assembly according to an embodiment of the present invention;
FIG. 2 is a schematic side view of the storage element assembly in the embodiment of FIG. 1;
FIG. 3 is a schematic diagram of a storage element in the embodiment of FIG. 1;
FIG. 4 is a schematic structural diagram of a connecting piece in the embodiment of FIG. 1;
FIG. 5 is a schematic diagram in which the storage element assembly according to the embodiment of FIG. 1 is installed on the mainboard;
FIG. 6 is a schematic diagram in which the mainboard is not installed with the storage element assembly in the embodiment of FIG. 5;
FIG. 7 is a schematic diagram of a heat dissipation airflow of an electronic device in the embodiment of FIG. 1; and
FIG. 8 is a schematic diagram of comparing the embodiment of FIG. 1 with a control embodiment to measure interference noise.

### DETAILED DESCRIPTION OF PREFERRED EMBODIMENTS

Terms used in the description of the embodiments of the present invention, for example, orientation or position relation such as "above" and "below" are described according to the orientation or position relation shown in the drawings. The above terms are used for facilitating description of the present invention rather than limiting the present invention, i.e., indicating or implying that the mentioned elements have to have specific orientations and to be configured in the specific orientations. In addition, terms such as "first" and "second" involved in the description or claims are merely used for naming the elements or distinguishing different embodiments or ranges rather than limiting the upper limit or lower limit of the quantity of the elements.

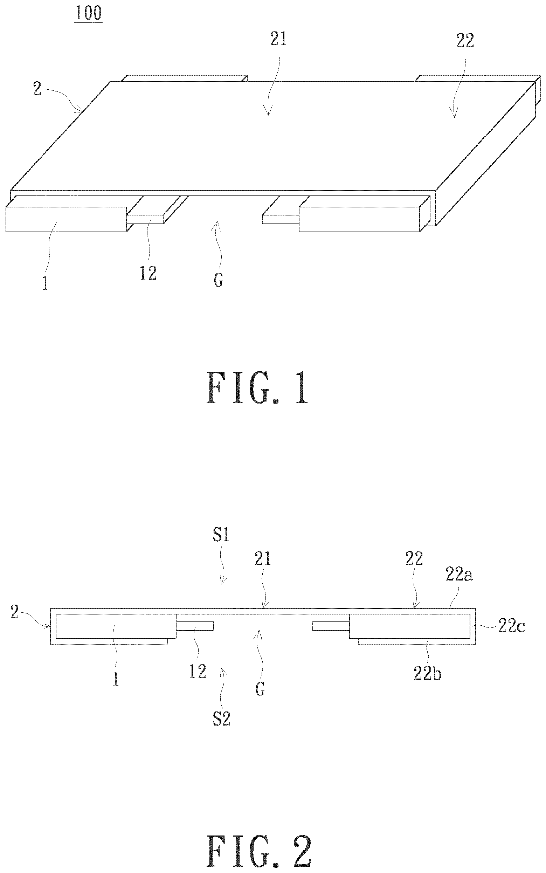

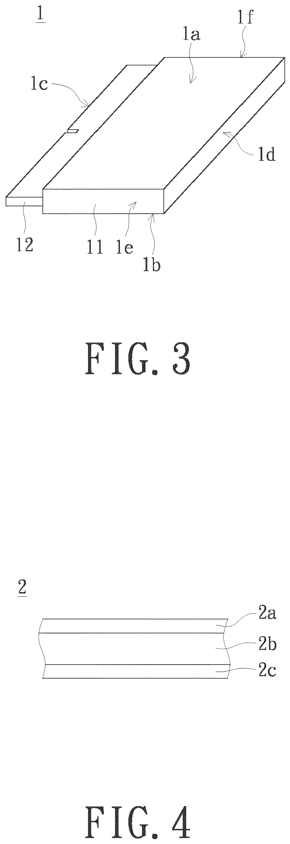

FIG. 1 is a schematic three-dimensional view of a storage element assembly according to an embodiment of the present invention. FIG. 2 is a schematic side view of the storage element assembly in the embodiment of FIG. 1. FIG. 3 is a schematic diagram of a storage element in the embodiment of FIG. 1. The elements in the drawings are all schematic only and not drawn to actual scale. As shown in FIG. 1 to FIG. 3, a storage element assembly 100 in an embodiment includes two storage elements 1 and a connecting piece 2. Each storage element 1 has a first side 1a and a second side 1b opposite to each other and a third side 1c and a fourth side 1d opposite to each other. The third side 1c and the fourth side 1d are connected between the first side 1a and the second side 1b, and the third sides 1c of the two storage elements 1 are opposite to each other and spaced by a gap G. The connecting piece 2 has two wrapping portions 22 and a bridging portion 21. Each wrapping portion 22 wraps the first side 1a, the second side 1b, and the fourth side 1d of one of the storage elements 1, and the bridging portion 21 is connected between the wrapping portions 22 and covers the gap G.

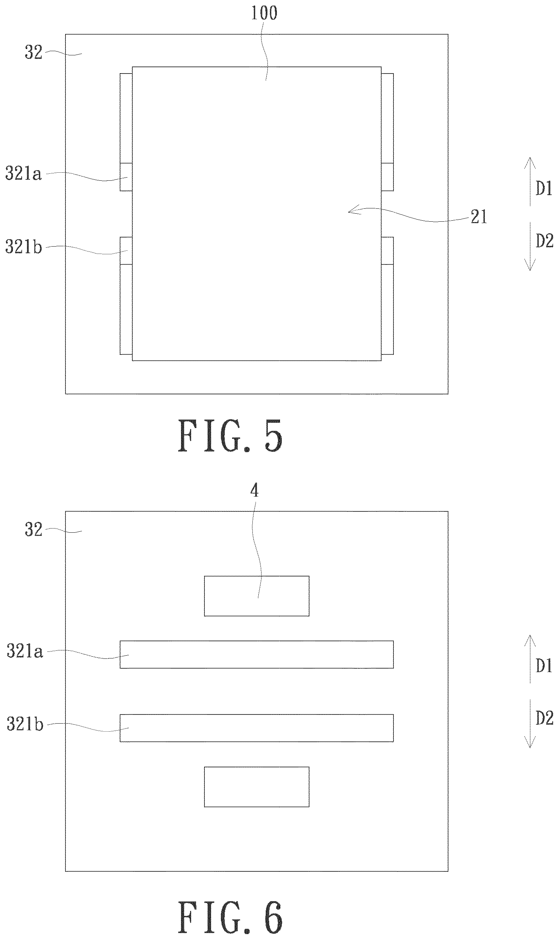

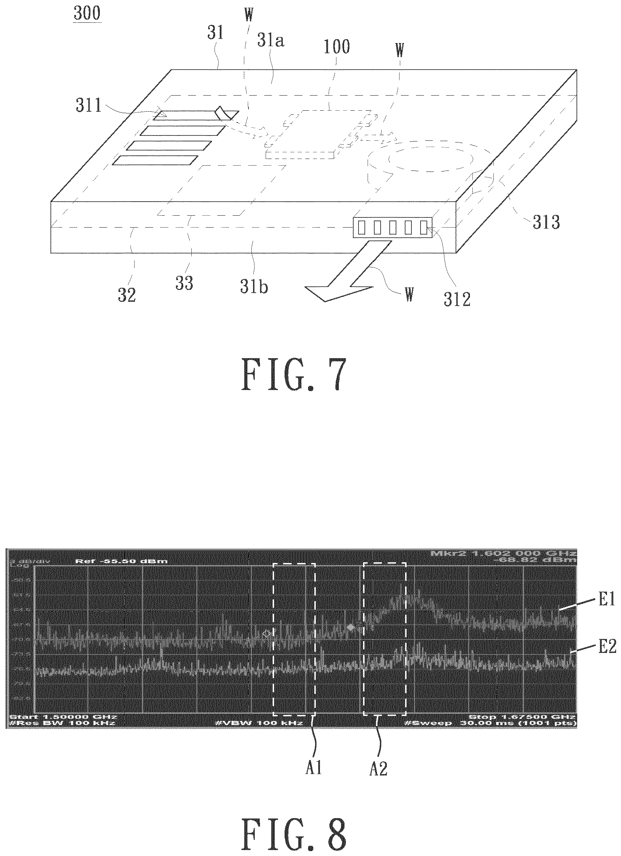

Specifically, as shown in FIG. 3, in this embodiment, the storage element 1 is, for example, a memory installed in an electronic device 300 in FIG. 7, but the type of the storage element 1 is not limited in the present invention. The electronic device 300 is, for example, a portable electronic device, such as a laptop or a tablet, but is not limited to this. Each storage element 1 has a body 11 and an electrical connection portion 12. The body 11 includes, for example, a substrate (not shown in figure) and a required electronic part (not shown in figure) as the memory. In addition to the first side 1a, the second side 1b, the third side 1c, and the fourth side 1d, the body 11 has a fifth side 1e and a sixth side 1f opposite to each other along different directions. The fifth side 1e and the sixth side 1f are connected between the first side 1a and the second side 1b and are further connected between the third side 1c and the fourth side 1d. In this embodiment, the fifth side 1e and the sixth side 1f of the storage element 1 are not covered by the connecting piece 2, but are not limited to this. The electrical connection portion 12 of the storage element 1 includes, for example, a plurality of connecting fingers (not shown in figure) suitable to be inserted and electrically connected into connecting slots (see 321a and 321b in FIG. 5) of the electronic device 300.

As shown in FIG. 2, the storage element assembly 100 is, for example, in a thin plate shape and has a first side S1 and a second side S2 opposite to each other, and the second side S2 is suitable to face a mainboard 32 of the electronic device 300 when the storage element assembly 100 is connected to the electronic device 300. The bridging portion 21 is located, for example, on the first side S1 of the storage element assembly 100. The wrapping portion 22 is, for example, a U-shaped groove, and openings of the two grooves formed by the two wrapping portions 22 are opposite to each other (see a position of the electrical connection portion 12 in FIG. 2). Each wrapping portion 22 includes a first portion 22a, a second portion 22b, and a turning portion 22c. The first portion 22a is adjacently connected to the bridging portion 21 and thus located on the first side 1a, while the second portion 22b is connected to the first portion 22a through the turning portion 22c and located on the second side S2 of the storage element assembly 100.

FIG. 4 is a schematic structural diagram of a connecting piece in the embodiment of FIG. 1. In this embodiment, the connecting piece 2 is, for example, a flexible sheet and structurally includes an insulating layer 2a, a metal layer 2b, and a wave-absorbing layer 2c. The metal layer 2b is superimposed on the wave-absorbing layer 2c and located between the wave-absorbing layer 2c and the insulating layer 2a, for example, and during assembly, the wave-absorbing layer 2c is located between the metal layer 2b and the storage element 1 and thus may serve as the insulating layer. The specific arrangement of the metal layer 2b, the wave-absorbing layer 2c, and the insulating layer 2a is not limited to the above example, and relative positions thereof may be changed according to requirements. For example, in embodiments not shown in figure, the insulating layer 2a may not be provided. In other embodiments, the wave-absorbing layer 2c may be located between the metal layer 2b and the insulating layer 2a, and the connecting piece 2 is in contact with a surface of the storage element 1 via the insulating layer 2a. In addition, in some other embodiments, a number of the layers may also be changed according to requirements. The metal layer 2b is made of, but not limited to, aluminum foil, for example. The wave-absorbing layer 2c is made of, for example, an existing material that may be used to solve the problem of interference noise of electromagnetic waves, which may be selected according to requirements. The insulating layer 2a is made from, but not limited to, polyethylene terephthalate (PET), for example.

FIG. 5 is a schematic diagram in which the storage element assembly according to the embodiment of FIG. 1 is installed on the mainboard. FIG. 6 is a schematic diagram in which the mainboard is not installed with the storage element assembly in the embodiment of FIG. 5. FIG. 7 is a schematic diagram of a heat dissipation airflow of an electronic device in the embodiment of FIG. 1. As shown in FIG. 5 to FIG. 7, the electronic device 300 is, for example, a laptop and includes, for example, a mainboard 32, a housing 31, and a processor 33.

The mainboard 32 is installed in the housing 31 and includes a connecting slot 321a, a connecting slot 321b, two thermally conductive pads 4, and a fan 313. The connecting slot 321a and the connecting slot 321b are parallel to each other, for example, and an opening direction D1 of the connecting slot 321a is opposite to an opening direction D2 of the connecting slot 321b. In this embodiment, a distance between the connecting slot 321a and the connecting slot 321b corresponds to a length of the bridging portion 21, for example. In other words, in this embodiment, the connecting piece 2 is suitable to press the two storage elements 1 against the connecting slot 321a and the connecting slot 321b through a tension provided by the bridging portion 21 and the first portions 22a located on two sides of the bridging portion 21, but is not limited to this.

As shown in FIG. 5 and FIG. 6, the two thermally conductive pads 4 are arranged on one side of the connecting slot 321a and one side of the connecting slot 321b, respectively, and one thermally conductive pad 4 is located in front of the opening direction D1 of the connecting slot 321a, while the other thermally conductive pad 4 is located in front of the opening direction D2 of the connecting slot 321b. There is no limitation on a material of the thermally conductive pads 4, which may be selected according to requirements, and in other embodiments, a number of the thermally conductive pads 4 may be increased.

As shown in FIG. 2, FIG. 5, and FIG. 6, when the storage element assembly 100 is installed on the mainboard 32, the electrical connection portions 12 located on the third sides 1c of the storage elements 1 are inserted into the connecting slot 321a and the connecting slot 321b, respectively, and the bridging portion 21 covers the connecting slot 321a and the connecting slot 321b. The second portions 22b of the two wrapping portions 22 cover the two thermally conductive pads 4, respectively.

As shown in FIG. 7, the housing 31 has, for example, an air inlet 311 and an air outlet 312. The housing 31 further includes a bottom board 31a and a side board 31b. The bottom board 31a and the side board 31b are, for example, perpendicular to each other in this embodiment, but may form an angle in other embodiments. For example, the air inlet 311 is located on the bottom board 31a, and the air outlet 312 is located on the side board 31b, but they are not limited thereto. The fan 313 is, but not limited to, a centrifugal fan 313, for example. The fan 313 is arranged in the housing 31 and located on one side of the air outlet 312, and is suitable to bring air from the air inlet 311 into an internal space of the housing 31 to generate an airflow W.

As shown in FIG. 7, the storage element assembly 100 is arranged between the air inlet 311 and the fan 313, allowing the airflow W to flow through a space between the connecting piece 2 and the housing 31. There is no limitation on an arrangement direction of the storage element assembly 100 (and the connecting slots 321a and 321b), which is, for example, a direction in which the airflow W can pass through the gap G (see FIG. 1 and FIG. 2). When passing through the storage element assembly 100, the airflow W flows through a surface of the first side S1 and can also flow through a surface (see FIG. 2, the gap G) of the second side S2 where the bridging portion 21 is located. The processor 33 is arranged on the mainboard 32, for example, and is located in the housing 31 and on one side of the storage element assembly 100.

To illustrate the advantages of the storage element assembly 100, reference is made to FIG. 7 and Table 1 below. Table 1 is an experimental table for comparing a temperature of the two storage elements 1 of the storage element assembly 100 in this embodiment with a temperature of two storage elements 1 of an existing storage element assembly (excluding the connecting piece 2). To distinguish the two storage elements 1, they are represented as a first storage element and a second storage element in Table 1.

**Table 1**

| | Existing storage element assembly | | Storage element assembly 100 | |
|---|---|---|---|---|
| Ambient temperature (°C) | 25 | 60 | 25 | 60 |
| Temperature (°C) of first storage element | 77.5 | 99.5 | 74.9 | 97.0 |
| Temperature (°C) of second storage element | 84.2 | 101.5 | 80.1 | 98.7 |
| Temperature (°C) of bottom board 31a | 50.1 | | 49.4 | |

It can be seen from FIG. 7 that when the processor 33 as a heat source for the electronic device 300 is close to the storage element assembly 100, one storage element 1 in the storage element assembly 100 is closer to the processor 33 than the other storage element 1. Because the processor 33 is the heat source, different storage elements 1 will be affected by distances from the processor 33 and thus have a difference in temperature. Therefore, it can be seen in Table 1 that under the same ambient temperature, the two storage elements 1 (the first storage element and the second storage element) have different temperatures.

It can be seen from Table 1 that compared with the existing storage element assembly, the two storage elements 1 of the storage element assembly 100 in this embodiment both have low temperatures, indicating that the storage element assembly 100 has good heat dissipation efficiency and the two storage elements 1 (the first storage element and the second storage element) in the storage element assembly 100 have a small temperature difference.

Because noise of interference with wireless communication of the electronic device 300 may be caused at positions where the connecting slot 321a and the connecting slot 321b are located, the interference noise caused at the positions is expected to be low in practice. FIG. 8 is a schematic diagram of comparing the embodiment of FIG. 1 with a control embodiment to measure interference noise. In a measurement way, an instrument is arranged above the two connecting slots 321a and 321b (relative to the mainboard 32), where a line E1 in FIG. 8 represents noise measured in a control group installed with the existing storage element assembly, and a line E2 represents noise measured in an experimental group installed with the storage element assembly 100. A frequency band shown in a box A1 and a frequency band shown in a box A2 are a frequency band used by a global positioning system (GPS) and a frequency band used by a global navigation satellite system (GNSS), respectively.

It can be seen from FIG. 8 that compared with the noise measured by the control group, the noise measured by the experimental group is lower in all frequency ranges than the noise measured by the control group, indicating that the storage element assembly 100 in this embodiment has a function of reducing the interference noise.

Based on the above description, the storage element assembly according to the present invention has good heat dissipation performance because the storage element assembly is wrapped by the wrapping portions of the connecting piece and the bridging portion capable of increasing a heat dissipation area is formed between the two wrapping portions. The electronic device according to the present invention includes the storage element assembly and thus has good heat dissipation performance. The two storage elements are both wrapped by the connecting piece, and the connecting slots for connecting the storage elements are also covered by the bridging portion, so signal interference caused by the storage elements can be reduced and thus interference noise can be reduced.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A storage element assembly (100), comprising:
two storage elements (1), wherein each of the two storage elements (1) has a first side (1a), a second side (1b), a third side (1c) and a fourth side (1d), the first side (1a) and the second side (1b) are opposite to each other, the third side (1c) and the fourth side (1d) are opposite to each other, the third side (1c) and the fourth side (1d) are connected between the first side (1a) and the second side (1b), and the third sides (1c) of the two storage elements (1) are opposite to each other and spaced by a gap (G); and
a connecting piece (2), having two wrapping portions (22) and a bridging portion (21), wherein each of the two wrapping portions (22) wraps the first side (1a), the second side (1b), and the fourth side (1d) of one of the two storage elements (1), and the bridging portion (21) is connected between the two wrapping portions (22) and covers the gap (G).

2. The storage element assembly (100) according to claim 1, wherein the connecting piece (2) comprises a metal layer (2b) and a wave-absorbing layer (2c), the metal layer (2b) is superimposed on the wave-absorbing layer (2c), and the wave-absorbing layer (2c) is located between the metal layer (2b) and the two storage elements (1).

3. The storage element assembly (100) according to claim 2, wherein the connecting piece (2) further comprises an insulating layer (2a), and the metal layer (2b) is located between the wave-absorbing layer (2c) and the insulating layer (2a).

4. The storage element assembly (100) according to any of claims 1 to 3, wherein each of the third sides (1c) is provided with an electrical connection portion (12).

5. An electronic device (300), comprising:
a mainboard (32); and
the storage element assembly (100) as claimed in any one of claims 1 to 4, arranged on the mainboard (32).

6. The electronic device (300) according to claim 5, wherein the mainboard (32) is provided with two thermally conductive pads (4), and the two wrapping portions (22) are connected to the two thermally conductive pads (4), respectively.

7. The electronic device (300) according to claim 5, wherein the mainboard (32) is provided with two connecting slots (321a, 321b), the electrical connection portions (12) of the third sides (1c) are inserted into the two connecting slots (321a, 321b), respectively, and the bridging portion (21) covers the two connecting slots (321a, 321b).

8. The electronic device (300) according to any of claims 5 to 7, further comprising a fan (313) configured to generate an airflow (W), wherein the airflow (W) passes through the connecting piece (2).

9. The electronic device (300) according to claim 8, further comprising a housing (31), wherein the housing (31) comprises an air inlet (311) and an air outlet (312), the fan (313) is arranged at the air outlet (312), the storage element assembly (100) is located between the air inlet (311) and the fan (313), and the airflow (W) flows through a space between the connecting piece (2) and the housing (31).

10. The electronic device (300) according to claim 9, wherein the housing (31) comprises a bottom board (31a) and a side board (31b), the air inlet (311) is located on the bottom board (31a), and the air outlet (312) is located on the side board (31b).
